# EUROPEAN PATENT SPECIFICATION

(11) **EP 1 755 219 B1**
(45) Date of publication and mention of the grant of the patent: **16.07.2008**
(21) Application number: 06020936.8
(22) Date of filing: 14.10.1998
(51) Int. Cl.: H03J 1/00

(54) **Multi-tuner data multiplex broadast receiver**
Datenmultiplex-Rundfunkempfänger mit mehreren Tunern
Récepteur de radiodiffusion à multiplexage de données à plusieurs tuners

(30) Priority: 15.10.1997 JP 28223897
(43) Date of publication of application: 21.02.2007
(62) Divisional of application: 98308389.0
(73) Proprietor: PIONEER ELECTRONIC CORPORATION, Meguro-ku, Tokyo (JP)
(72) Inventor: Kobayashi, Hiroshi c/o Pioneer Electronic Corp., Ohaza Yamada Kawagoe-shi Saitama (JP)
(74) Representative: Maury, Richard Philip

(56) References cited:
- EP-A- 0 584 839
- DE-A- 4 236 621
- PATENT ABSTRACTS OF JAPAN vol. 013, no. 270 (E-776), 21 June 1989 (1989-06-21) & JP 01 060115 A (FUJITSU TEN LTD), 7 March 1989 (1989-03-07)

## Description

### BACKGROUND OF THE INVENTION

### Field of the Invention

The invention relates to a data multiplex broadcasting receiver, and more particularly to a data multiplex broadcasting receiver having at least two tuners.

### Description of Related Art

The RDS (Radio Data System) as one of data multiplex broadcasting systems is an FM multiplex broadcasting system recommended by Consultative Committee on Internation (CCIR) and is a system which can provide various services such as the display of the station name of broadcasting stations, automatic selection of a station, automatic reception of traffic information, and the like for a vehicle mounted radio receiver as a main target.

Such a radio data system is described in patent publication EP 0 584 839 A1. It comprises a data multiplex broadcasting receiver having two tuners. The first tuner receives the broadcasted FM signal together with the multiplexed data signals. The second tuners monitors the frequencies received by the first tuner for determining the reception with the best quality.

In cases where a receiving state of a broadcasting wave from a certain broadcasting station deteriorates, the RDS receiver can execute a network following process to control a tuning frequency so as to automatically receive a broadcasting wave from another broadcasting station which belongs to the same broadcasting network as that of the relevant broadcasting station (in other words, which presents the same program as that of the relevant broadcasting station) based on a program identification (PI) code in RDS data multiplexed to the received broadcasting wave and whose receiving state is good.

The RDS data can include information showing a receiving frequency of the broadcasting wave from the other relevant broadcasting station as alternate frequency (AF) data of the present receiving frequency. The RDS receiver can also fetch the AF data, store it as an AF list, and perform a switching control of a tuning frequency in accordance with the AF list at the time of execution of the network following process.

In the control of the tuning frequency, however, the broadcasting wave from another broadcasting station in a good receiving state cannot always be received immediately after the start of the network following process. Since there is a possibility that the operations to set the tuning frequency, evaluate the receiving state after the station selection, and confirm the coincidence of the PI code are executed many times until the broadcasting wave can be received, if an audio sound is continuously reproduced for such a period of time, noises due to a frequent change of the tuning frequency will be generated.

As a countermeasure for the noise sound generation, hitherto, a method of muting the audio output for a period of time of the tuning frequency control is used. Even if this method is used, however, the output sound is once interrupted and the intermittence of the audio output is eventually performed, causing a situation that an audio sound which is bothering to the listener is generated.

As another method which can contribute to the countermeasure for the noises, there is an RDS radio receiver disclosed in Japanese Patent Kokai No. Sho 64-60115. The receiver is designed in a manner such that two tuners are used and for a period of time during which a desired program is received by one of the tuners, another broadcasting station which provides the same program as that received by one tuner is scanned by the other tuner by using the PI code, thereby always allowing the audio sound to be generated from the tuner having a higher receiving level.

With the above method, the audio sound is generated from one tuner while the other tuner is scanning and only when the broadcasting wave which is determined such that the audio reproducing quality is better than that received by the one tuner is detected, the audio source is switched to the audio output from the other tuner. Noises on the audio output, therefore, due to the scan of the other tuner, namely, due to the control of the tuning frequency are not generated and the intermittence of the audio output due to the muting as mentioned above does not occur.

In the receiver disclosed in the above-described publication document, however, since the two tuners are provided only for the purpose such that the program which is provided by the broadcasting that is being received at present on the basis of the PI code is continued at a high audio output quality, an advantage of the construction in which a plurality of tuners are provided cannot be sufficiently utilized. In addition, there is an aspect that the operation and effect which can be attained are too little for the high costs associated with the use of a plurality of tuners.

### OBJECTS AND SUMMARY OF THE INVENTION

The invention has been made in view of the above points, and it is therefore an object of the invention to provide a data multiplex broadcasting receiver which can effectively make the most of the ability of each of a plurality of tuners which are arranged.

According to the invention, there is provided a data multiplex broadcasting receiver having at least two tuners, comprising: one and another tuners each of which can independently demodulate a predetermined modulation signal from a reception wave carrying the modulation signal; control means for performing, when a generation of an interruption program which satisfies a predetermined interrupting condition is detected, a control operation to generate an audio output of the interruption program through the one tuner; and data reproducing means for demodulating a data signal multiplexed to the reception wave, decoding the demodulated data signal, and reproducing broadcasting related information data, wherein the control means performs a tuning control to the other tuner so as to select a station which transmits a specific broadcasting wave in which information regarding a network to which one broadcasting station to transmit a broadcasting wave of said reception wave belongs and another different network has been multiplexed to the broadcasting wave, and after completion of the tuning control of the specific broadcasting wave, the control means monitors whether the interrupting condition has been satisfied or not on the basis of the broadcasting related information data in the reception wave of the other tuner.

The receiver further has storing means for storing the information regarding the broadcasting station and the station to transmit the specific broadcasting wave can be set to a station selected by the information stored in the storing means. In this receiver, it is also possible to adopt a structure as follows. If the tuning control of the specific broadcasting wave based on the information stored in the storing means is unsuccessful, a tuning control is performed to the other tuner so as to demodulate a second specific broadcasting wave in which the information regarding the network to which the one broadcasting station for transmitting the broadcasting wave belongs and the other different network has been multiplexed to the broadcasting wave and which is transmitted by a station different from the station that is selected by the information stored in the storing means, and after the completion of the tuning control of the second specific broadcasting wave, whether the interrupting condition has been satisfied or not is monitored based on the broadcasting related information data in the reception wave of the other tuner.

In this receiver, it is also possible to adopt a structure such that the control means executes the tuning control to the other tuner so as to demodulate a multiplexed broadcasting wave in which a data signal including information regarding the network to which the one broadcasting station for transmitting the broadcasting wave belongs has been multiplexed and, after the completion of the tuning control of the multiplexed broadcasting wave, whether the interrupting condition has been satisfied or not is monitored on the basis of the broadcasting related information data in the reception wave of the other tuner.

The receiver further has storing means for storing information regarding the broadcasting stations and the multiplexed broadcasting wave can be also set to a broadcasting wave which is transmitted by the station selected by the information stored in the storing means. It is also possible to construct as follows. When the tuning control of the multiplexed broadcasting wave based on the information stored in the storing means is unsuccessful, the tuning control is performed to the other tuner so as to demodulate a second multiplexed broadcasting wave in which a data signal including the information regarding the broadcasting station has been multiplexed and the information stored in the storing means is not included in the data signal, and after the completion of the tuning control of the second multiplexed broadcasting wave, whether the interrupting condition has been satisfied or not is monitored on the basis of the broadcasting related information data in the reception wave of the other tuner.

According to the invention, there is provided a data multiplex broadcasting receiver having at least two tuners, comprising one and another tuners each of which can independently demodulate a predetermined modulation signal from a reception wave carrying the modulation signal; control means for performing, when a generation of an interruption program which satisfies a predetermined interrupting condition is detected, a control operation to generate an audio output of the interruption program through the one tuner: and data reproducing means for demodulating a data signal multiplexed to the reception wave, decoding the demodulated data signal, and reproducing broadcasting related information data, wherein when either one of the following conditions of a) an interrupting mode is set and a mode for performing a tuning control to the other tuner except for the interrupting mode is not set, and b) the one tuner is tuned to a multiplexed broadcasting wave in which a data signal including the information regarding the broadcasting station is not multiplexed is satisfied, the control means performs the tuning control to the other tuner so as to demodulate a specific broadcasting wave in which the data signal has been multiplexed, and after the completion of the tuning control of the specific broadcasting wave, the control means mainly executes an interrupting process for monitoring whether the interrupting condition has been satisfied or not on the basis of the broadcasting related information data in the reception wave of the other tuner as a process for performing the tuning control to the other tuner.

In the receiver, even when the following condition of c) the one tuner is tuned to the multiplexed broadcasting wave in which a data signal which does not include alternate frequency information has been multiplexed is satisfied, the control means also mainly executes the interrupting process as a process for performing the tuning control to the other tuner.

In the receiver, when another mode for performing the tuning control to the other tuner is further set, the control means also executes in a time-division fashion the interrupting process and a process corresponding to the other mode.

As a process corresponding to the other mode, a process for searching another broadcasting station of a network to which the broadcasting station selected by the one tuner belongs on the basis of the broadcasting related information data can be applied.

Further, as a specific broadcasting wave, it is possible to use a broadcasting wave in which the information regarding the network to which one broadcasting station to transmit the broadcasting wave belongs and another different network has been multiplexed to the broadcasting wave.

### BRIEF DESCRIPTION OF THE DRAWINGS

Fig. 1 is a block diagram showing a schematic construction of an RDS data multiplex broadcasting receiver of an embodiment according to the invention;
Fig. 2 is a diagram showing a data format of RDS data of a 14A group;
Fig. 3 is a diagram showing a data format of RDS data of a 14B group;
Fig. 4 is a diagram showing a data format of RDS data of a 0A group;
Fig. 5 is a former half flowchart showing a procedure for an interrupting process which is executed by a system controller in the receiver in Fig. 1;
Fig. 6 is a latter half flowchart showing the procedure for the interrupting process which is executed by the system controller in the receiver in Fig. 1:
Fig. 7 is a flowchart showing a procedure for a switching process which is executed by the system controller in the receiver in Fig. 1; and
Fig. 8 is a block diagram showing a schematic construction of an RDS data multiplex broadcasting receiver of another embodiment according to the invention.

### DETAILED DESCRIPTION OF THE PREFERRED EMBODIMENTS

The invention will now be described in detail hereinbelow with reference to the drawings.

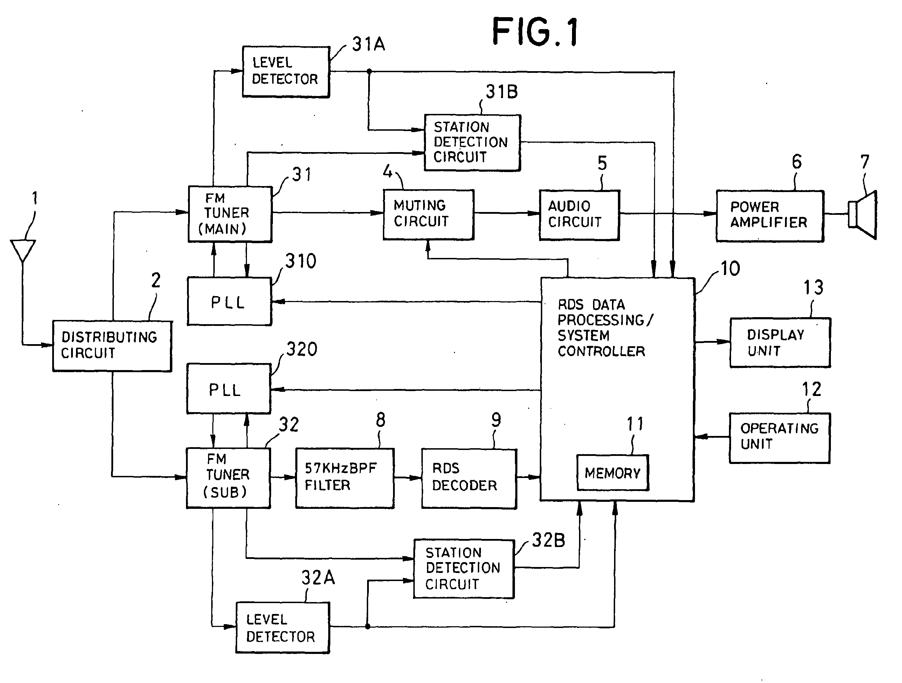

Fig. 1 shows a schematic construction of an RDS data multiplex broadcasting receiver of an embodiment according to the invention.

In Fig. 1, a radio wave which is received by an antenna 1 includes an FM broadcasting wave (RDS broadcasting wave) to which an RDS signal including the PI code or AF data has been multiplexed or an FM broadcasting wave to which the RDS signal is not multiplexed. A reception output of the antenna 1 is supplied as a reception signal to FM tuners 31 and 32 via a distributing circuit 2. The FM tuner 31 functions as a main tuner of the receiver and mainly demodulates a signal regarding an audio sound as information to be inherently reproduced. The FM tuner 32 functions a sub tuner of the receiver and mainly demodulates the RDS signal. With respect to a point that a modulation signal is independently demodulated from the reception wave holding an FM signal as a predetermined modulation signal, both of the tuners have the equivalent function.

Each of the FM tuners 31 and 32 has: a front end for selecting a radio wave of a desired broadcasting station by what is called a tuning operation and converting to an intermediate frequency (IF) of 10.7 MHz; an IF amplifier for amplifying a signal of the IF; and an FM detecting circuit for FM detecting from an amplification output of the IF amplifier and demodulating an audio signal (those component elements are not shown). In more detail, each front end includes a mixer (not shown) as frequency converting means, obtains a local oscillation signal to the mixer by a PLL synthesizer system using PLL (Phase Locked Loop) circuit 310 or PLL circuit 320 including a programmable frequency divider (not shown), and executes a station selecting operation by controlling a frequency dividing ratio of the programmable frequency divider by a controller 10, which will be explained hereinafter.

The audio signal demodulated by the FM tuner 31 is supplied to an audio circuit 5 via a muting circuit 4. In case of, for example, a stereo broadcasting, the audio circuit 5 separates it to an audio signal of an L (left) channel and an audio signal of an R (right) channel by what is called a stereo demodulating circuit (not shown). The audio signal of each channel of the audio circuit 5 is supplied to a corresponding power amplifier 6 and is power amplified. The power amplifier 6 drives a speaker 7 in response to the audio signals and allows an acoustic sound to be generated.

At the post stage of the sub FM tuner 32, an RDS signal detecting system which functions as data reproducing means for demodulating and decoding a data signal included in the received wave and is used to detect an RDS signal (data) from an FM detection output of the sub FM tuner 32 is formed. In more detail, there are provided: a band pass filter (BPS) 8 for extracting a sub-carrier of 57 kHz, namely, an RDS signal component which was amplitude modulated by a bi-phase coded data signal from the detection output from the FM tuner 32; and an RDS decoder 9 to which the extracted RDS signal component is supplied and which performs demodulating and decoding processes and error detecting and error correcting processes in association with the decoding synchronously with the RDS signal component. Since the constructions and operations of the BPS 8 and RDS decoder 9 are well known in JP-A-8-79016 or the like, the detailed description is omitted here. A decoded output of the RDS decoder 9 is supplied as RDS data to the RDS data processing/system controller (hereinbelow, abbreviated to a controller) 10 of a microcomputer construction and is used for various controls.

As means for detecting a receiving state of the FM tuner 31, there are provided: a level detector 31A for detecting a reception signal level (field intensity) on the basis of an IF signal level which is obtained from the IF amplifier in the FM tuner 31; and a station detection circuit 31B for generating a station detection signal indicative of the detection of the station when the reception signal level is equal to or higher than a predetermined level and the detection output having S-shaped curve characteristics in the FM detector in the FM tuner 31 lies within a predetermined level range. As means for detecting a receiving state of the FM tuner 32 as well. a similar level detector 32A and a similar similar detection circuit 32B are provided. Signals indicative of reception signal levels which are generated from the level detectors 31A and 32A and station detection signals which are generated from the station detection circuits 31B and 32B are supplied to the controller 10.

In this instance, the contents of the RDS data regarding the characteristics of the embodiment will now be described in detail.

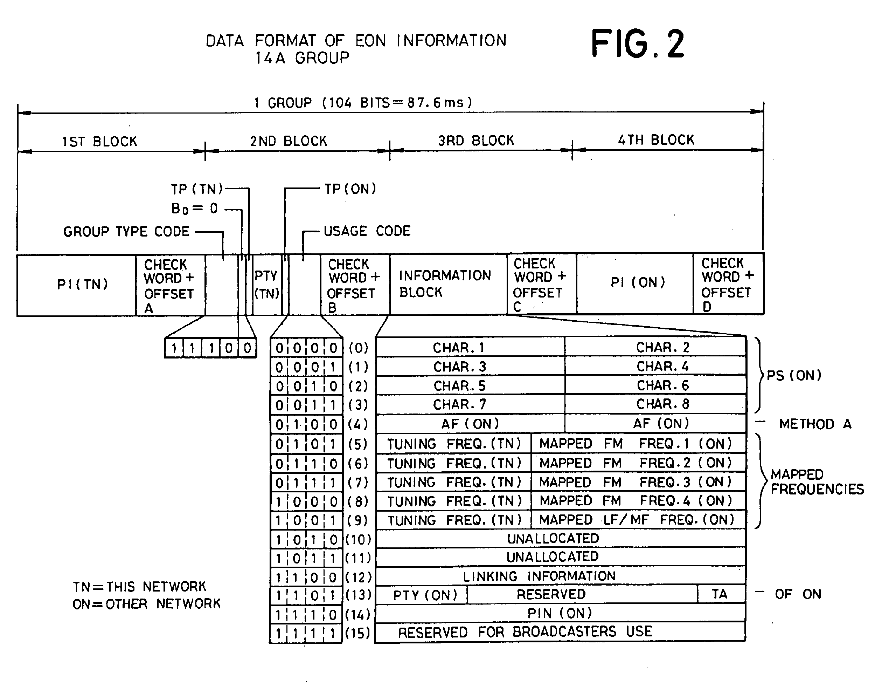

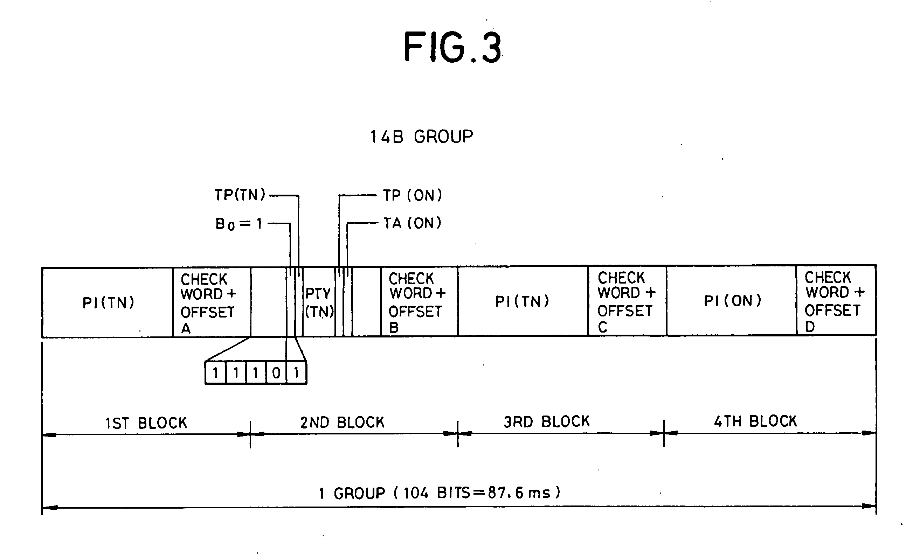

The RDS data indicates broadcasting relation information data and is constructed by 16 kinds of groups of 0 to 15 groups in which 104 bits are set to one group and each group is constructed by four blocks and which include undefined groups. Each block is constructed by 26 bits comprising: an information word of 16 bits and a check word and an offset word of 10 bits. Among the undefined groups of the RDS data, 14A and 14B groups are set to EON information (Enhanced Other Networks Information) by a format as shown in Figs. 2 and 3. Not only own network information indicative of information of the network to which the broadcasting station of the RDS data belongs but also the other network information can be transmitted.

In Figs. 2 and 3, "(TN)" and "(ON)" added to the ends of the code names indicate a code regarding the own network (This Network) and a code regarding the other network (Other Network), respectively.

In the 14A group shown in Fig. 2, a program ID code PI (TN) of this network is allocated to the first block. The PI (TN) code is constructed by 16 bits comprising: a nation code (4 bits) indicative of a country to which the broadcasting belongs; a broadcasting area code (4 bits) indicative of an area to which the broadcasting belongs; and a program reference number code (8 bits) which is used for identification of the main network. The PI code is a code which is mainly used for enabling the same program to be continuously preferably presented even if the receiving state deteriorates by searching the station of the same PI code by the receiver.

A group type code, a version bit B0, a traffic program station code TP (TN), a program type code PTY (TN), a traffic program station code TP (ON), and an information classification code (Usage code) are allocated to the second block of the 14A group.

The group type code is a 4-bit code to identify what is sent as data that is subsequently transmitted, designates 16 groups of 0 to 15 by using four bits, and designates a version A or B by the subsequent version bit B0 (1 bit). B0 = "0" indicates the A version and B0 = "1" indicates the B version. As shown in Fig. 2, therefore, as a group type code of the 14A group, "1110" (14 in the decimal expression) and "0" are allocated. As shown in Fig. 3, "1110" and "1" are allocated to the group type code of the 14B group.

The traffic program station code TP (TN) is a 1-bit code showing the presence or absence of the traffic program station in this network. The program type code PTY (TN) is a code indicative of a program type of this network. Five bits are allocated to the PTY code in order to identify 32 kinds of program types (music program, news program, sports program, and the like) of 0 to 31. The program kinds are decided on the basis of a predetermined rule.

The traffic program station code TP (ON) is a 1-bit code indicating whether the traffic program station exists in the other network or not. By always monitoring the TP (ON) code, therefore, the receiver can know whether the traffic program station exists in the other network or not in a real-time manner.

The usage code is a 4-bit code showing the kind of information described in the third block. As shown in Fig. 2, 16 kinds of information of (0) to (15) are specified by using 4-bit codes "0000" to "1111".

Character codes (char. 1 to char. 8) of broadcasting station names (program service names) are described in the information blocks (0) to (3) of the third block. Broadcasting station alternate frequency data AF (ON) of the other network by a Method A format is described in the information block (4), broadcasting station frequency data (Tuning frequency (TN)) of this network and broadcasting station frequency data (Mapped FM frequency (ON)) of the other network by a format of Mapped Frequencies are - described in information blocks (5) to (9), respectively. As for the broadcasting station frequency data in the information blocks (4) or (5) to (9), any one of the formats is previously selected by the broadcasting station and the broadcasting station frequency data is transmitted by the selected format.

Information blocks (10) and (11) of the third block are not used. Predetermined link information data is stored into an information block (12).

The program type code PTY (ON) is described in an information block (13) of the third block. The program type code is a code indicative of the program type of the other network and has a bit format similar to that of the PTY (TN).

As for data and information blocks (14) and (15) of the third block which were not mentioned above, since they are not directly concerned with the characteristics of the embodiment, their explanations are omitted.

A program ID code PI (ON) of the other network is allocated to the fourth block.

In the 14B group shown in Fig. 3, the program ID code PI (TN) of this network is allocated to the first block. A group ID code "11101" indicative of the 14B group, traffic program station code TP (TN), program type code PTY (TN), traffic program station code TP (ON), and a broadcasting announcement code TA (ON) are allocated to the second block. By monitoring the broadcasting announcement code TA (ON) of the other network, therefore, the receiver can know a fact that the traffic information is being broadcasted by any station in the other network.

The program ID code PI (TN) of this network is allocated to the third block of the 14B group and the program ID code PI (ON) of the other network are allocated to the fourth block.

Although the RDS data of each group is almost periodically and repetitively multiplex transmitted, a group which is relatively often transmitted is a 0A group.

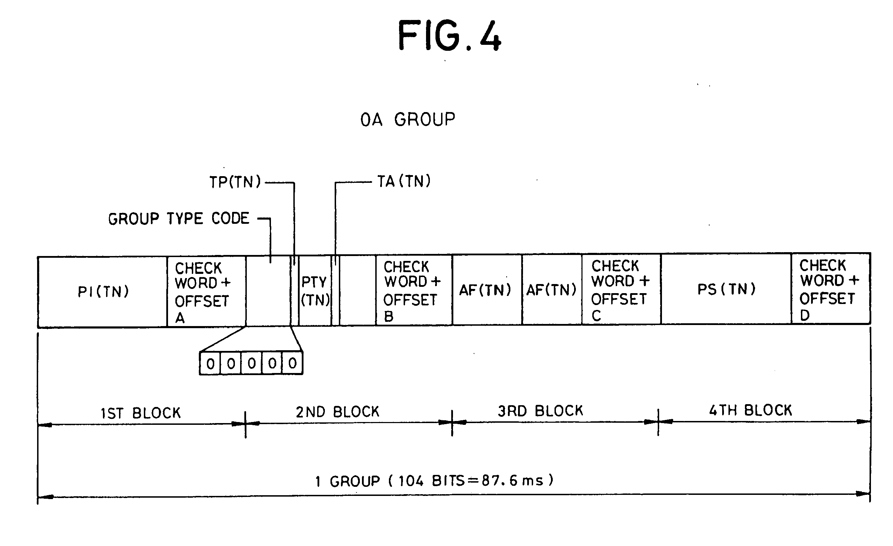

Fig. 4 shows a data format of the 0A group. The PI (TN) code of this network is allocated to the first block. "00000" as a group type code and the TP (TN) code and PTY (TN) code of this network are allocated to the second block. By monitoring the PTY (TN) code, the receiver can know which type of the program is being broadcasted in this network.

The broadcasting station alternate frequency data AF (TN) of this network is allocated to the third block. The broadcasting station name data PS (Program Service name) of 16 bits for displaying the station name of the broadcasting station by the display is allocated to the fourth block. The other data construction is similar to that of the data of the 14A and 14B groups.

Returning to Fig. 1, the controller 10 can fetch the information words of each block of the RDS data which is input on a group unit basis as mentioned above, namely, the PI codes, AF data, TP codes, TA codes, PTY codes, and the like regarding this network and the other network and can store into an internal memory 11. The memory 11 can function as storing means for storing the alternate frequency data (AF data) showing the frequency of the broadcasting wave belonging to the network as an Af list every network.

An example of the AF list will now be described in detail. In the sub tuner 32, if a broadcasting wave which includes the EON information and has been generated from one RDS broadcasting station belonging to a certain network A is received, the PI codes and AF data of the network A and the other networks are transferred from the RDS signal in the broadcasting wave by the RDS decoder 9 to the system controller 10 and are written into the memory 11. By the writing into the memory 11, the frequency data of the broadcasting station belonging to the network A of the broadcasting station (a) selected at present by the sub tuner 32 is stored as an AF list (TN) into a predetermined memory area in the memory 11 and the frequency data of the broadcasting stations belonging to the networks other than the network A is also stored as an AF list (ON).

The memory 11 is also used as what is called a preset channel memory.

In the memory 11 as a preset channel memory, for example, the information of the broadcasting station which has previously been selected by the user through an operating unit 12 is stored by the user. The user designates a desired broadcasting station from the stored contents, thereby enabling the broadcasting to be promptly easily listened.

On the basis of a station selecting command (including the designation of a preset channel) accompanied with a receiving frequency from the operating unit 12 or on the basis of the AF data finally selected as a result of the network following process, the controller 10 controls the frequency dividing ratio of the programmable frequency divider in the PLL circuit 310 which functions in cooperation with the tuner 31, so that it can select a desired broadcasting station or another broadcasting station belonging to the same network as the broadcasting station whose program is being received at present.

As a characteristic operation of the embodiment, the controller 10 controls the main tuner 31 so as to receive the interruption program when an interrupting condition, which will be explained hereinafter, is satisfied.

The controller 10 also similarly controls the sub tuner 32 by using a PLL circuit 320. The control of the sub tuner 32 can be mainly separated into: a control in an interrupting mode to monitor the generation of a program which satisfies the interrupting condition; and a control in a processing mode to monitor a receiving state of another broadcasting station belonging to the same network as that of the broadcasting station selected by the main tuner 31. The details of those controls will be clearly explained hereinafter.

The controller 10, further, generates a switching signal to turn on the muting circuit 4 at the time of station selection.

The operating unit 12 and a display unit 13 are provided on a front panel of the RDS receiver. The display unit 13 functions as notifying means for notifying of various operating states of the controller 10 and the receiver and displays in accordance with a display control signal from the controller 10.

The characteristic operation of the receiver will now be described in detail.

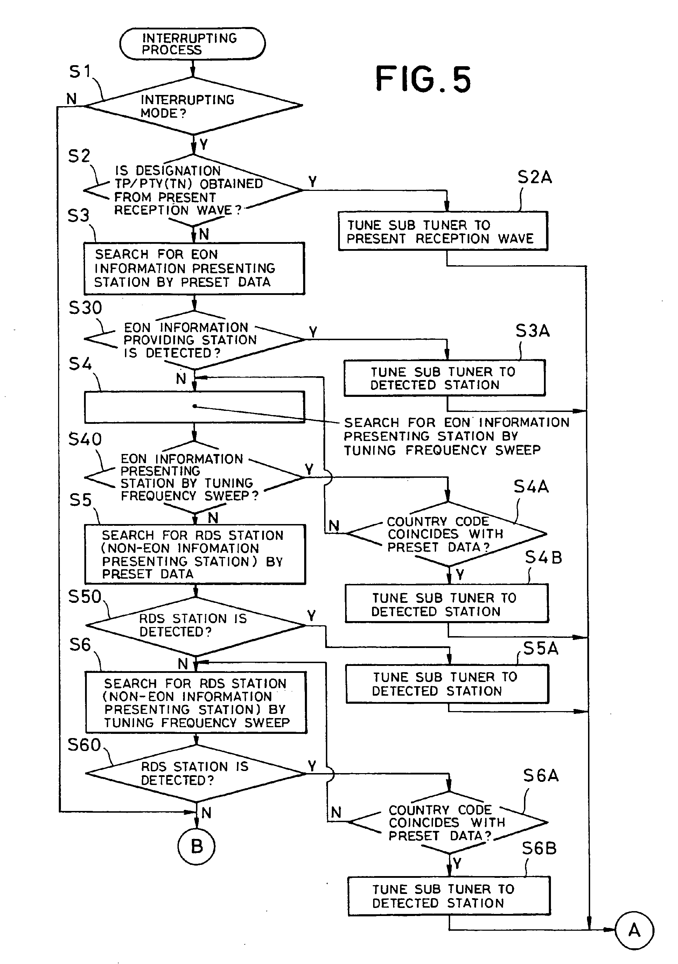

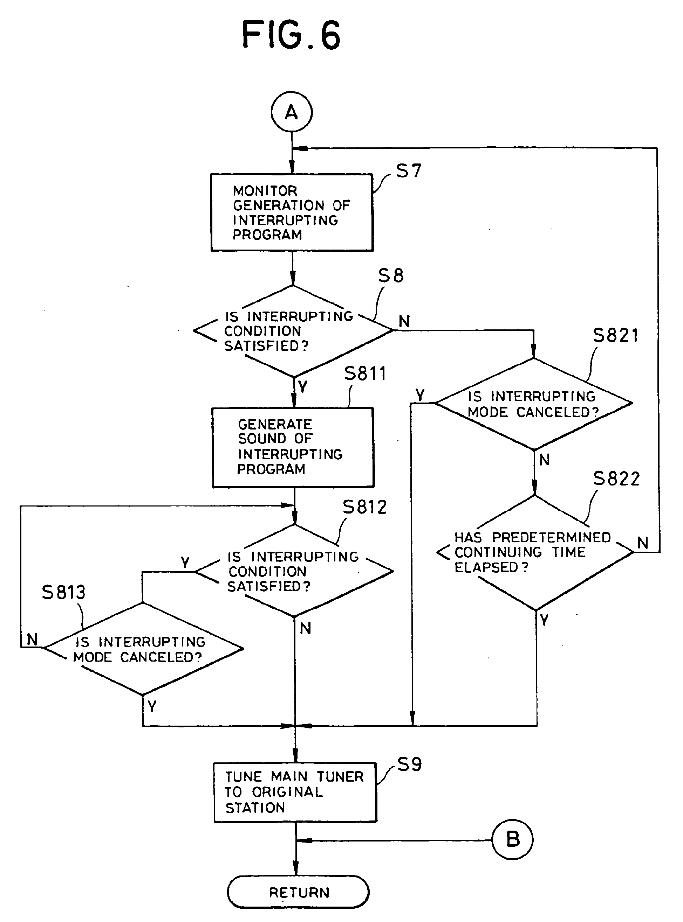

The controller 10 executes the interrupting process according to flowcharts as shown in Figs. 5 and 6.

In the interrupting process, mainly, the sub tuner 32 monitors the generation of an interruption program, namely, traffic information, a program desired by the user, or a program that is regarded to be close to the desired program while the main tuner 31 is receiving a certain broadcasting or generating an audio sound thereof and, when the program is detected, the sub tuner 32 instructs so as to perform an audio output with respect to the interruption program through the main tuner 31. While the interruption program is not found, the sub tuner 32 monitors the generation of the interruption program by the data which is obtained from the broadcasting station which satisfies a predetermined standby condition to which a priority has been allocated.

The controller 10 first discriminates whether the control mode is the interrupting mode or not (step S1). If NO, the interrupting process is finished and the processing routine is returned to the original main routine. The receiver again waits for a timing to shift to the interrupting process.

The interrupting mode is designated, for example, by the user through the operating unit 12 and can be further divided into: a traffic information interrupting mode for preferentially generating traffic information by a sound; and a designated program interrupting mode for preferentially generating a program which was arbitrarily designated by the other user by a sound.

When either one of the interrupting modes is designated, the controller 10 discriminates whether the broadcasting station which is at present being received by the main tuner 31 presents traffic information or not or whether program identification information is derived from the broadcasting wave which is at present being received or not (step S2). Specifically speaking, the controller 10 controls the PLL circuit 320 so that the sub tuner 32 selects the same broadcasting station as that of the main tuner 31 and discriminates whether the TP (TN) code or PTY (TN) code (hereinafter, referred to as a "designation PTY (TN)") is derived from the RDS decoder 9 or not. If the TP (TN) code is derived in case of the traffic information interrupting mode or if the PTY (TN) is obtained in case of the designated program interrupting mode, the controller 10 establishes the station selecting state of the sub tuner 32, namely, holds it in the same station selecting state as that of the main tuner 31 (step S2A) and monitors the generation of the interruption program in this station selecting state (step S7).

In step S2, if none of the TP (TN) code and the designation PTY (TN) code is derived, by preset data, the controller 10 controls the sub tuner 32 so as to search an EON information presenting station which generates a specific broadcasting wave to which a data signal including information regarding the broadcasting station belonging to the other network as mentioned above has been multiplexed (step S3). The preset data used here is data stored every network in the internal memory 11 of the controller 10. Information of at least one tuning frequency to select the broadcasting station which has previously been selected and set by the user into the memory 11 through the operating unit 12 is included in the preset data. The controller 10 sends a control signal to the PLL circuit 320 so that the sub tuner 32 is tuned to the tuning frequency instructed by the preset data. When the tuning of the sub tuner 32 is completed, the controller 10 confirms about the EON information presenting station. This confirmation is performed by checking whether the RDS data of the 14A and 14B groups including the EON information as mentioned above is derived from the broadcasting station selected by the tuner 32 or not. If the EON information presenting station cannot be confirmed, the controller 10 executes the tuning control of the sub tuner 32 and the confirmation of the EON information presenting station by the preset data with respect to the next broadcasting station.

The controller 10 discriminates whether the EON information presenting station has been detected or not on the basis of the result of the search of the EON information presenting station by the preset data (step S30). When it is detected, the controller holds the sub tuner 32 in the station selecting state of the detected EON information presenting station (step S3A) and monitors the generation of the interruption program in this station selecting state (step S7). Steps S3, S30, and S3A correspond to the tuning control process of the sub tuner about the first specific broadcasting wave.

If the present receiving station is improper as a monitor station to monitor the generation of the interruption program in the interrupting mode, the sub tuner 32 preferentially monitors the generation of the interruption program in the station selecting state of the EON information presenting station. It is, therefore, preferable because not only the information of this network but also the information of the other network can be covered as a monitoring range of the interruption program. Moreover, the EON information presenting station to monitor the generation of the interruption program on the basis of the preset data, instead of the mere EON information presenting station is searched for, thereby allowing the sub tuner 32 to wait for the generation of the interruption program in the station selecting state of the EON information presenting station which has already been selected by the user. It is, consequently, more desirable because the broadcasting station which will be desired by the user at a high possibility can be preferentially set into the sub tuner 32.

In step S30, if it is determined that the EON information presenting station is not detected, the controller 10 controls the sub tuner 32 so as to search the EON information presenting station by the sweep of the tuning frequency (step S4). In more detail, the controller 10 sends a control signal to the PLL circuit 320 so as to start the sweep of the tuning frequency in a receiving band that is peculiar to the sub tuner 32. In the sweep of the tuning frequency, the controller 10 grasps the receiving level and the local detecting state by a signal from the level detector 32A and a station detection signal from the station detection circuit 32B, thereby discriminating whether the receiving state is good or not. If it is determined that the receiving state is good, the controller 10 stops the sweep of the tuning frequency at this time point and confirms whether the reception wave of the sub tuner 32 is the wave from the EON information presenting station or not (step S40). This confirmation is executed in a manner similar to the confirmation in step S3 mentioned above.

When it is decided that the EON information presenting station has been detected in step S40, the controller 10 discriminates whether a country code of the PI data included in the broadcasting wave from the detected EON information presenting station coincides with that of the preset data or not (step S4A). Only when they coincide, the controller 10 holds the sub tuner 32 in the station selecting state of the detected EON information presenting station (step S4B) and monitors the generation of the interruption program in this station selecting state (step S7). On the contrary, when they do not coincide, the controller 10 shifts to step S4, restarts the sweep of the tuning frequency, and executes similar discrimination of the receiving state and confirmation of the EON information presenting station. Steps S4, S40. S4A, and S4B correspond to a tuning control process of the sub tuner about the second specific broadcasting wave.

The processes in steps S4, S40, S4A, and S4B will now be described in detail with regard to, particularly, the process in step S4A. Since the user ordinarily uses several languages which belong to one certain country or are limited, in many cases, the preset data that is selected and set by the user is consistently the information regarding the broadcasting station of the same country or one of a few specific countries. As shown in step S4A, therefore, if only the EON information presenting station which transmits the preset country code is selected, only the broadcasting station of the country which has been selected before by the user is selected as a station of a target to monitor the generation of the interruption program.

If the present receiving station is improper as a monitor station to monitor the generation of the interruption program in the interrupting mode and the search in step S3 is finished as being unsuccessful, the sweep of the tuning frequency in the receiving band of the sub tuner 32 is performed and the EON information presenting station is searched for. Not only the EON information presenting station belonging to the preset data, therefore, but also the EON information presenting station can be searched for so long as the reception of the sub tuner 32 is possible. Since the sub tuner 32, therefore, waits for the generation of the interruption program in the station selecting state of the EON information presenting station which does not belong to the preset data at a priority next to that of the EON information presenting station belonging to the preset data, the effect such that the information of the other network is included in the monitor targets of the generation of the interruption program can be maintained, so that it is preferable. Moreover, the EON information presenting station is searched for on the basis of the country code of the preset data here merely instead of the EON information presenting station which does not belong to the preset data. The sub tuner 32 waits for the generation of the interruption program in the station selecting state of the EON information presenting station of the country which was selected so far by the user. The broadcasting station that is closer to the desire of the user, therefore, can be preferentially set to the sub tuner 32, so that it is more preferable.

In step S40, when it is determined that the EON information presenting station is not detected, the controller 10 controls the sub tuner 32 so as to search the RDS station by the preset data (step S5). In more detail, the controller 10 sends a control signal to the PLL circuit 320 so that the sub tuner 32 is tuned to the tuning frequency that is instructed by the preset data. When the tuning of the sub tuner 32 is completed, the controller 10 confirms whether the reception wave of the sub tuner 32 is a wave from the RDS station or not. This confirmation is performed to discriminate whether the station selected by the tuner 32 is a broadcasting station for multiplex transmitting the RDS data irrespective of a discrimination result about whether the broadcasting wave includes the EON information or not. This confirmation is performed by checking whether the RDS data has been obtained from the RDS decoder 9 or not. Since the process in step S5 is executed when the search of the EON information presenting station is unsuccessful, the RDS station which does not present the EON information eventually becomes the search target here. If the RDS station cannot be confirmed, the controller 10 executes the tuning control of the sub tuner 32 and the confirmation of the RDS station by the preset data with regard to the next broadcasting station.

The controller 10 discriminates whether the RDS station has been detected or not (step S50) on the basis of a result of the search of the RDS station by the preset data. When the RDS station is detected, the controller keeps the sub tuner 32 in the station selecting state of the detected RDS station (step S5A) and monitors the generation of the interruption program in this station selecting state (step S7). Steps S5, S50, and S5A correspond to the tuning control process of the sub tuner regarding the first multiplex broadcasting wave.

If the present receiving station is improper as a monitor station to monitor the generation of the interruption program in the interrupting mode and the searches in steps S3, S4, and S4A are unsuccessful, the sub tuner 32 waits for the generation of the interruption program in the station selecting state of the EON information presenting station belonging to the preset data at a priority next to that of the EON information presenting station which does not belong to the preset data. Even if the information of the other networks cannot be covered as a monitoring range of the generation of the interruption program, therefore, it is possible to guarantee that at least the information of this network is covered as such a monitoring range, so that it is preferable. Moreover, the RDS station to monitor the generation of the interruption program is searched for here on the basis of the preset data instead of the mere RDS station. The sub tuner 32 waits for the generation of the interruption program in the station selecting state of the RDS station which has already been selected by the user. The broadcasting station in which a possibility such that the user desires it is high can be preferentially set into the sub tuner 32, so that it is more preferable.

In step S50, when it is determined that the RDS station is not detected, the controller 10 controls the sub tuner 32 so as to search the RDS station by the sweep of the tuning frequency (step S6). In more details, the controller 10 sends a control signal to the PLL circuit 320 so as to start the sweep of the tuning frequency in the receiving band that is peculiar to the sub tuner 32. In the sweep of the tuning frequency, the controller 10 grasps a receiving level and a local detecting state from the signal from the level detector 32A and the station detection signal from the station detection circuit 32B, thereby discriminating whether the receiving state is good or not. If it is determined that the receiving state is good, the controller 10 stops the sweep of the tuning frequency at that time point and confirms whether the reception wave of the sub tuner 32 is a wave from the RDS station or not (step S60). This confirmation is performed in a manner similar to that in step S5 mentioned above.

When it is decided that the RDS station was detected in step S60, the controller 10 discriminates whether the country code of the PI data included in the broadcasting wave from the detected RDS station coincides with that of the preset data or not (step S6A). Only when they coincide, the controller 10 keeps the sub tuner 32 into the station selecting state of the detected RDS station (step S6B) and monitors the generation of the interruption program in this station selecting state (step S7). On the contrary, when they do not coincide, the controller 10 is shifted to step S6. restarts the sweep of the tuning frequency, and similarly executes a discrimination of the receiving state and a confirmation of the RDS station. Steps S6, S60, S6A. and S6B correspond to the tuning control process of the sub tuner with respect to the second multiplex broadcasting wave.

The meaning of the process in step S6A is also similar to the process in step S4A mentioned above. That is, by the process in step S6A, only the broadcasting station of the country which has already been selected so far by the user is selected as a station of the monitor target of the interruption station.

If the present receiving station is improper as a monitor station to monitor the generation of the interruption program in the interrupting mode and all of the searches in steps S3, S4, S4A, and S5 are unsuccessful, the sweep of the tuning frequency in the receiving band of the sub tuner 32 is performed, thereby searching the RDS station. Not only the RDS station belonging to the preset data, therefore, but also the RDS stations can be searched for so long as the stations can be received by the sub tuner 32. Since the sub tuner 32, accordingly, waits for the generation of the interruption program in the station selecting state of the RDS station which does not belong to the preset data at a priority next to that of the RDS station belonging to the preset data, an effect such that the information held in the RDS data is included in the monitor target of the generation of the interruption program can be maintained and it is preferable. Moreover, the RDS station is searched for on the basis of the country code of the preset data merely instead of the RDS station which does not belong to the preset data and the sub tuner 32 waits for the generation of the interruption program in the station selecting state of the RDS station of the country which has already been selected so far by the user. The broadcasting station that is closer to the desire of the user, consequently, can be preferentially set into the sub tuner 32, so that it is more preferable.

In step S60, when it is determined that the RDS station is not detected, the controller 10 finishes the interrupting process, returns to the original main routine, and again waits for a timing to shift to the interrupting process.

After the processing routine was shifted to step S7, the controller 10 discriminates whether the interrupting condition has been satisfied or not (step S8). In step S7, the tuning frequency of the sub tuner 32 is continued so that each code of the RDS data and the data which are necessary in step S8 can be fetched and the generation of the interruption program based on the RDS data which is mainly derived from the reception wave of the sub tuner 32 is detected. The interrupting condition is set as follows.
I. In case of the traffic information interrupting mode:
   i) The TP (TN) code or TP (ON) code which is derived from the reception wave is equal to 1.
   ii) The TA (TN) code or TA (ON) code corresponding to the TP code is equal to 1.
   iii) The receiving state is good.
II. In case of the designated program interrupting mode:
   i) The PTY (TN) code or PTY (ON) code which is derived from the reception wave coincides with the designation PTY code.
   ii) The receiving state is good.

It should be noted that as will be understood from the above explanation, the TP (TN) code and the TA (TN) code can be confirmed in the second block in the RDS data of the 0A group. The TP (ON) code which is derived from the reception wave can be confirmed in the second blocks in the RDS data of the 14A and 14B groups. The TA (ON) code which is obtained from the reception wave can be confirmed in the second block in the RDS data of the 14B group. The PTY (TN) code which is obtained from the reception wave can be confirmed in the second block in the RDS data of the 0A group. The PTY (ON) code can be confirmed in the third block in the RDS data of the 14A group, in details, in the information block of (13) in the third block.

It is possible to set that the condition for the good receiving state is satisfied when the controller 10 compares the signal which is supplied from the level detector 32A with a predetermined value and the former one is larger than the latter one.

In the flow shifted from steps S3A and S4A to step S7, since the broadcasting station which is tuned in step S7 is the EON information presenting station, in this case, the controller 10 also executes the tuning control of the sub tuner 32 such as to pursue the information of the broadcasting station which satisfies the interrupting condition on the basis of the EON information as a monitoring operation of the generation of the interruption program. For example, when the RDS data in which the TP (TN) code is equal to 1 cannot be derived from the tuned broadcasting wave, if it is confirmed that the TP (ON) code and TA (ON) code are equal to 1 by checking them, the operation for allowing the sub tuner 32 to select the corresponding ON station and confirming the TA (TN) code in this state is executed.

In step S8, when it is determined that the interrupting condition as mentioned above is satisfied, the controller 10 generates an audio sound of the broadcasting program which satisfies the interrupting condition. In this instance, the tuning control of the main tuner 31 is executed as necessary (step S811). After that, the controller 10 again confirms whether the interrupting condition has been satisfied or not (step S812). In step S812, when it is determined that the interrupting condition is not satisfied or until the interrupting mode is cancelled, the tuning state of the main tuner 31 is held (step S813).

If the interrupting mode is cancelled by a method such that the user issues a cancelling instruction through the operating unit 12 or the like, the controller 10 sets the main tuner 31 into the original receiving state. In this instance, as necessary, the controller 10 executes the tuning control of the main tuner 31 so as to return the main tuner 31 to the receiving state which has been set just before the audio output of the interruption program is generated through the main tuner 31 (step S9).

In step S8, when it is determined that the interrupting condition is not satisfied, the controller 10 discriminates whether the interrupting mode has been cancelled or not (step S821). If it is not cancelled, a check is made to see if the monitor of the generation of the interruption program in step S7 has continuously been executed for a predetermined time (step S822). In step S822, when it is decided that the continuation time is shorter than the predetermined time, the controller 10 is shifted to step S7. By repeating steps S7, S8, S821, and S822, while continuing the tuning frequency of the sub tuner 32 by setting the predetermined time to an upper limit value, on the basis of the reception wave, whether the program which satisfies the interrupting condition has been generated or not is discriminated.

In step S821, when it is determined that the interrupting mode was cancelled and if the elapse of a predetermined time from the start of the continuation of the tuning frequency of the sub tuner 32 is decided in step S822 , the controller 10 finishes the present process.

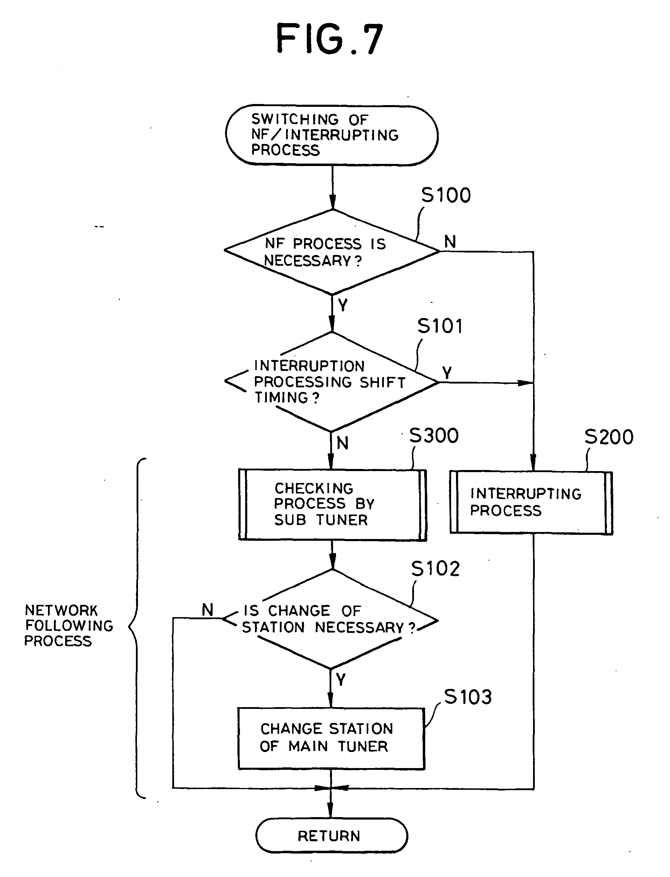

Although the interrupting process has been described above, the controller 10 further also executes a switching process according to a flowchart as shown in Fig. 7. This process is a process for executing in parallel in a time-division fashion a network following process as a process to execute the tuning control of the sub tuner 32 and the interrupting process.

In Fig. 7, the controller 10 discriminates whether there is a necessity of the network following (NF) process or not (step S100). It is now assumed that the network following process is unnecessary when either one of the following conditions is satisfied.
a) The network following processing mode is not set.
b) The main tuner 31 selects a non-RDS station.

When it is confirmed that either one of the conditions is satisfied, the controller 10 determines that there is no need to execute the network following process, and mainly executes the interrupting process (step S200). Step S200 corresponds to the subroutine of the processes shown in Figs. 5 and 6.

In step S100, when it is impossible to confirm that either one of the conditions is satisfied, the controller 10 determines that it is necessary to execute the network following process and discriminates whether an interruption processing shift timing has come or not (step S101). The timing to shift to the interrupting process is generated only when the interrupting mode is set. In this case, the controller 10 periodically generates this timing.

Until the interruption processing shift timing comes in step S101, the controller 10 performs the tuning control process of the sub tuner 32 so as to check the receiving states of the other broadcasting station of the network to which the broadcasting station selected at present by the main tuner 31 belongs (step S300).

In the checking process here, two processes, which will be explained hereinbelow, are executed.

One is an AF list check such that the station selection of the sub tuner 32 based on each AF data in the AF list is performed by using the AF list (TN), whether the PI code corresponding to the broadcasting station selected at present by the main tuner 31 can be obtained from the reception wave of the sub tuner 32 or not is confirmed, and the receiving state of the reception wave in which the above confirmation could be made, for example, the level of the signal from the level detector 32A is sequentially stored into, for example, the memory 11 in correspondence to the information of the tuning frequency of the reception wave. The other is a receiving band check such that the sweep of the tuning frequency in the receiving band of the sub tuner 32 is performed without using the AF list (TN), whether the PI code corresponding to the broadcasting station selected at present by the main tuner 31 can be obtained from the reception wave of the sub tuner 32 or not is discriminated, and the receiving state of the reception wave in which such a confirmation could be made is sequentially stored into, for example, the memory 11 in correspondence to the information of the tuning frequency of the reception wave.

After the checking process, the controller 10 discriminates whether the receiving state stored by the checking process is better than the receiving state of the main tuner 31 or not (step S102). When the stored receiving state is determined to be better, the controller 10 decides that the station selection of the main tuner 31 should be changed and tunes the main tuner 31 in accordance with the information of the tuning frequency stored in correspondence to the receiving state which was decided to be better (step S103). The network following process is finished. Among the receiving states stored by the checking process, if there is not any receiving state better than the receiving state of the main tuner 31, the controller 10 continues the station selecting state of the main tuner 31 and finishes the network following process.

As a condition for the case that the network following process in step S100 is unnecessary, it is also possible to add the following condition c) that although the main tuner 31 selects the RDS station, the AF list of this network cannot be derived from the broadcasting wave of this station.

However, if this condition is set, a matching of the whole process should be maintained by removing the foregoing receiving band check from the checking process which is executed in step S300. By adding the above condition, the vain network following process can be omitted.

According to the switching process, the interrupting process (S200) can be executed in a proper situation and can be preferably reconciled with the network following process.

In the embodiment described in the foregoing, when the controller 10 confirms the RDS data of the broadcasting wave received by the main tuner 31, the controller 10 performs a tuning control to the sub tuner 32 so as to be set into the same station selecting state as that of the main tuner 31 and indirectly confirms the RDS data which is eventually obtained from the output of the sub tuner 32 as RDS data regarding the reception wave of the main tuner 31. A construction, however, having a form different from that mentioned above can be also used.

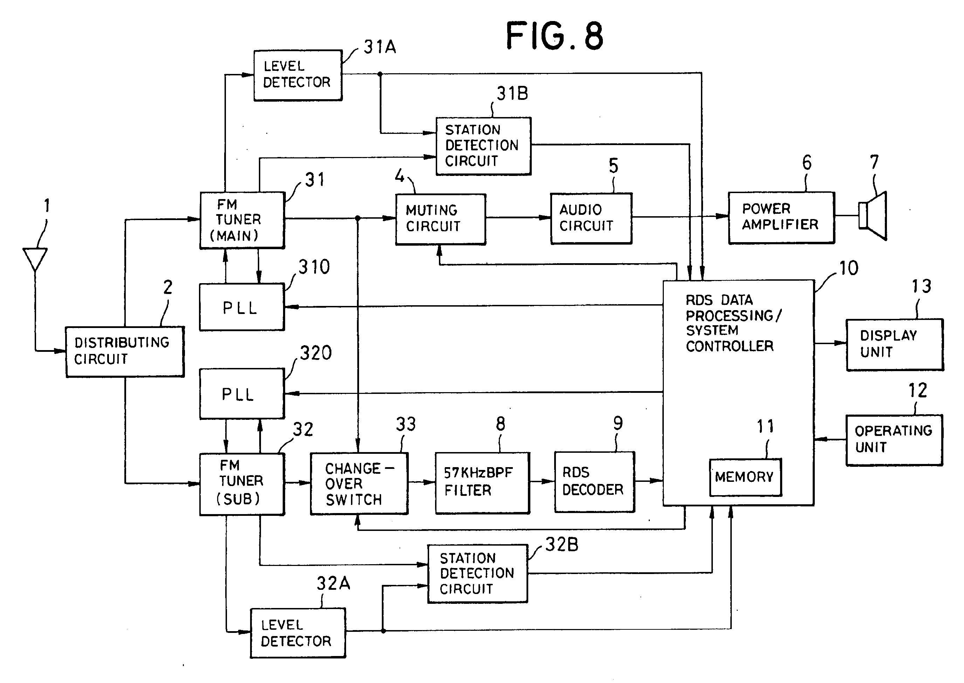

Fig. 8 shows a data multiplex receiver according to another embodiment having the above different construction.

In Fig. 8, portions similar to those shown in Fig. 1 are designated by the same reference numerals. In the receiver according to this embodiment, a change-over switch 33 is provided at the front stage of the BPF 8. The switch selectively supplies the output signal of the main tuner 31 and the output signal of the sub tuner 32 to the BPF 8. The control signal is also supplied from the controller 10 to the change-over switch 33. The change-over switch 33 operates so as to supply either one of the output signals of the main tuner 31 and the sub tuner 32 to the BPF 8 in response to the control signal.

With this construction, when the controller 10 confirms the RDS data of the broadcasting wave received by the main tuner 31, the controller 10 controls the change-over switch 33 so that the output signal of the main tuner 31 is supplied to the BPF 8, thereby enabling the RDS data of the broadcasting wave received by the main tuner 31 to be directly fetched. When a necessity to fetch the RDS data of the broadcasting wave received by the main tuner 31 occurs on the process, therefore, the controller 10 does not need to tune the sub tuner 32 to the same station selecting state as that of the main tuner 31 like the construction shown in Fig. 1. By merely controlling the change-over switch 33, the RDS data can be easily obtained.

Besides the constructions shown in Figs. 1 and 8, there is a construction to which the invention can be applied. For example, the invention can be also applied to a construction as disclosed in JP-A-64-60115.

As will be understood from the above description, the two tuners are used for not only what is called a network process in which the program which is presented by the broadcasting which is being received at present on the basis of the PI code is continued at a high audio output quality but also a process for efficiently monitoring the generation of the traffic information or an interruption program such as a user desired program or the like. The valid usage of the multi-tuners, therefore, is effected and the capability that is peculiar to the multi-tuners can be also effectively utilized. Particularly, a novel function such that it is possible to preferentially interrupt to a desired program even while the main tuner is selecting the non-RDS station can be realized.

Although the RDS receiver has been mentioned in each of the embodiments, the invention is not always limited to the RDS. The invention can be realized by any receiver of a type so long as the invention can be essentially applied.

In the above embodiments, although the coincidence between the received country code and the country code of the preset data has been discriminated in steps S4A and S6A as shown in Fig. 5, a district code which the PI code has can be also used in place of the country code. In brief, it is sufficient to construct such that the broadcasting station that is closer to the broadcasting station which has already been selected so far by the user can be searched for by using the preset data.

Further, although the search range is widened step by step and various searches are executed in steps S3, S4, S5, and S6 as shown in Fig. 5 in the embodiment, for example, a searching form can be also modified by a method such that the process in step S3 is omitted, the process in step S5 is omitted, or the like.

Although the various means have been described in each of the above embodiments, many other modifications are possible within a scope which can be designed by those skilled in the art.

As described in detail above, according to the invention, the data multiplex broadcasting receiver which can effectively utilize the abilities of a plurality of tuners which are arranged can be provided.

## Claims

1. A data multiplex broadcasting receiver having at least two tuners, which comprises:
one tuner (31) and another tuner (32) each of which is arranged independently to demodulate a predetermined modulation signal from a reception wave carrying said modulation signal;
control means (10); and
data reproducing means (9) arranged to demodulate a data signal multiplexed to said reception wave, to decode the demodulated data signal, and to reproduce broadcasting-related information data,
**CHARACTERISED IN THAT** said control means (10) is arranged:
to perform, when a generation of an interruption program which satisfies a predetermined interrupting condition is detected, a control operation to generate an audio output of said interruption program through said one tuner (31),
and to perform, when one of the following conditions:
a) a network follow processing mode to select another network station is not set, and
b) said one tuner (31) is tuned to a broadcasting wave in which a data signal including the information regarding the broadcasting station is not multiplexed,
is satisfied or both of the conditions a) and b) are satisfied, the tuning control to said other tuner (32) so as to demodulate a specific broadcasting wave in which the data signal has been multiplexed, and
after completion of the tuning control of said specific broadcasting wave, to mainly execute an interrupting process for monitoring whether said interrupting condition has been satisfied or not on the basis of said broadcasting-related information data in the reception wave of said other tuner (32) as a process for performing the tuning control to said other tuner (32).

2. A receiver according to Claim 1, wherein even in the case where the following condition of: c) said one tuner (31) is tuned to the multiplexed broadcasting wave in which a data signal which does not include alternate frequency information has been multiplexed, is satisfied, said control means (10) is arranged also mainly to execute said interrupting process as a process for performing the tuning control to said other tuner (32).

3. A receiver according to Claim 1 or 2, wherein when another mode for performing the tuning control to said other tuner (32) is further set, said control means is arranged also to execute said interrupting process and a process corresponding to said other mode in a manner of time-division.

4. A receiver according to Claim 3, wherein said process corresponding to said other mode is a process for searching another broadcasting station of a network to which the broadcasting station selected by said one tune (31) belongs based on said broadcasting related information data.

5. A receiver according to any one of Claims 1 to 4, wherein said specific broadcasting wave is a broadcasting wave in which the information regarding the network to which one broadcasting station to transmit said broadcasting wave belongs and another different network has been multiplexed to said broadcasting wave.

## Patentansprüche

1. Datenmultiplex-Rundfunkempfänger mit wenigstens zwei Tunern, der Folgendes umfasst:
einen Tuner (31) und einen weiteren Tuner (32), von denen jeder unabhängig angeordnet ist, um ein vorgegebenes Modulationssignal von einer Empfangswelle, die das Modulationssignal trägt, zu demodulieren;
ein Steuerungsmittel (10); und
ein Datenwiedergabemittel (9), das zum Demodulieren eines Datensignals, das zu der Empfangswelle multiplexiert wurde, zum Decodieren des demodulierten Datensignals und zum Wiedergeben rundfunkbezogener Informationsdaten, angeordnet ist,
**dadurch gekennzeichnet, dass** das Steuerungsmittel (10) dafür konfiguriert ist:
wenn eine Erzeugung eines Unterbrechungsprogramms, das eine vorgegebene Unterbrechungsbedingung erfüllt, detektiert wird, eine Steuerungsoperation auszuführen, um ein Audioausgangssignal des Unterbrechungsprogramms durch den einen Tuner (31) zu erzeugen;
und um, wenn eine der folgenden Bedingungen a) und b) oder beide erfüllt ist/sind:
a) ein Netzfolgeverarbeitungsmodus zum Auswählen einer anderen Netzstation ist nicht eingestellt, und
b) der eine Tuner (31) ist auf eine multiplexierte Rundfunkwelle abgestimmt, in der ein Datensignal, das die Informationen bezüglich der Rundfunkstation enthält, nicht multiplexiert ist,
die Abstimmungssteuerung für den anderen Tuner (32) so auszuführen, dass eine spezielle Rundfunkwelle demoduliert wird, in der das Datensignal multiplexiert wurde, und
nach Vollendung der Abstimmungssteuerung der speziellen Rundfunkwelle, hauptsächlich einen Unterbrechungsprozess zum Überwachen, auf der Grundlage der rundfunkbezogenen Informationsdaten in der Empfangswelle des anderen Tuners (32), auszuführen, ob die Unterbrechungsbedingung erfüllt wurde oder nicht, als einen Prozess zum Ausführen der Abstimmungssteuerung für den anderen Tuner (32).

2. Empfänger nach Anspruch 1, wobei selbst in dem Fall, wo die folgende Bedingung c) erfüllt ist: der eine Tuner (31) ist auf die multiplexierte Rundfunkwelle abgestimmt, in der ein Datensignal, das keine Alternativfrequenzinformationen enthält, multiplexiert wurde, das Steuerungsmittel (10) ebenfalls hauptsächlich zum Ausführen des Unterbrechungsprozesses als eines Prozesses zum Ausführen der Abstimmungssteuerung für den anderen Tuner (32) angeordnet ist.

3. Empfänger nach Anspruch 1 oder 2, wobei, wenn ferner ein anderer Modus zum Ausführen der Abstimmungssteuerung für den anderen Tuner (32) eingestellt ist, das Steuerungsmittel ebenfalls zum Ausführen des Unterbrechungsprozesses und eines Prozesses, der dem anderen Modus entspricht, im Zeitmultiplex angeordnet ist.

4. Empfänger nach Anspruch 3, wobei es sich bei dem Prozess, der dem anderen Modus entspricht, um einen Prozess zum Suchen einer anderen Rundfunkstation eines Netzes, zu dem die Rundfunkstation, die durch den einen Tuner (31) ausgewählt wurde, gehört, auf der Grundlage der rundfunkbezogenen Informationsdaten handelt.

5. Empfänger nach einem der Ansprüche 1 bis 4, wobei die spezielle Rundfunkwelle eine Rundfunkwelle ist, in der die Informationen bezüglich des Netzes, zu dem eine Rundfunkstation, die die Rundfunkwelle sendet, gehört, und eines weiteren, anderen Netzes zu der Rundfunkwelle multiplexiert wurde.

## Revendications

1. Récepteur de diffusion à multiplexage de données comportant au moins deux tuners, lequel comprend:
un tuner (31) et un autre tuner (32) dont chacun est agencé de manière indépendante pour démoduler un signal de modulation prédéterminé à partir d'une onde de réception qui est porteuse dudit signal de modulation;
un moyen de commande (10); et
un moyen de reproduction de données (9) agencé pour démoduler un signal de données qui est multiplexé sur ladite onde de réception, pour décoder le signal de données démodulé et pour reproduire des données d'information pertinentes de diffusion,
**caractérisé en ce que** ledit moyen de commande (10) est agencé:
pour réaliser, lorsqu'une génération d'un programme d'interruption qui satisfait une condition d'interruption prédéterminée est détectée, une opération de commande pour générer une sortie audio dudit programme d'interruption par l'intermédiaire dudit un tuner (31);
et pour réaliser, lorsque l'une des conditions a) et b) ou les deux qui suivent:
a) un mode de traitement de suivi de réseau pour sélectionner une autre station de réseau n'est pas établi; et
b) ledit un tuner (31) est accordé sur une onde de diffusion multiplexée selon laquelle un signal de données incluant l'information concernant la station de diffusion n'est pas multiplexé,
est/sont satisfaite(s), la commande d'accord sur ledit autre tuner (32) de manière à démoduler une onde de diffusion spécifique selon laquelle le signal de données a été multiplexé; et
pour exécuter, après l'achèvement de la commande d'accord de ladite onde de diffusion spécifique, essentiellement un processus d'interruption pour surveiller si oui ou non ladite condition d'interruption a été satisfaite et sur la base desdites données d'information pertinentes de diffusion dans l'onde de réception dudit autre tuner (32) en tant que processus pour réaliser la commande d'accord sur ledit autre tuner (32).

2. Récepteur selon la revendication 1, dans lequel, même dans le cas où la condition qui suit est constituée par c) ledit un tuner (31) est accordé sur l'onde de diffusion multiplexée selon laquelle un signal de données qui n'inclut pas une information de fréquence autre a été multiplexé, est satisfaite, ledit moyen de commande (10) est agencé pour exécuter également essentiellement ledit processus d'interruption en tant que processus pour réaliser la commande d'accord sur ledit autre tuner (32).

3. Récepteur selon la revendication 1 ou 2, dans lequel, lorsqu'un autre mode pour réaliser la commande d'accord sur ledit autre tuner (32) est en outre établi, ledit moyen de commande est agencé pour exécuter également ledit processus d'interruption et un processus correspondant audit autre mode d'une manière par répartition temporelle.

4. Récepteur selon la revendication 3, dans lequel ledit processus qui correspond audit autre mode est un processus pour rechercher une autre station de diffusion d'un réseau auquel la station de diffusion qui est sélectionnée au moyen dudit un tuner (31) appartient sur la base desdites données d'information pertinentes de diffusion.

5. Récepteur selon l'une quelconque des revendications 1 à 4, dans lequel ladite onde de diffusion spécifique est une onde de diffusion selon laquelle l'information concernant le réseau auquel une station de diffusion pour émettre ladite onde de diffusion appartient et concernant un autre réseau a été multiplexée sur ladite onde de diffusion.
